## Europäisches Patentamt

## European Patent Office

## Office européen des brevets

(19)

(11) Veröffentlichungsnummer: **0 250 919**
**B1**

(12)

# EUROPÄISCHE PATENTSCHRIFT

(45) Veröffentlichungstag der Patentschrift:
**05.09.90**

(51) Int. Cl.⁵: **H05K 9/00**, H03H 1/00

(21) Anmeldenummer: **87108119.6**

(22) Anmeldetag: **04.06.87**

(54) Netzleitungsfilter für 3-Phasen-Systeme.

(30) Priorität: **20.06.86 DE 3620761**

(43) Veröffentlichungstag der Anmeldung:
**07.01.88 Patentblatt 88/1**

(45) Bekanntmachung des Hinweises auf die Patenterteilung:
**05.09.90 Patentblatt 90/36**

(84) Benannte Vertragsstaaten:
**DE GB**

(56) Entgegenhaltungen:
**EP-A- 0 056 275**
**EP-A- 0 152 127**
**FR-A- 2 195 118**
**US-A- 3 909 623**

(73) Patentinhaber: **Siemens Aktiengesellschaft,
Wittelsbacherplatz 2, D-8000 München 2(DE)**

(72) Erfinder: **Schulz, Hans-Werner, Dipl.-Ing.,
Unterbibergstrasse 32, D-8000 München 63(DE)**
Erfinder: **Rogner, Ludwig, Eigenheimweg 21 a,
D-8400 Regensburg(DE)**

ACTORUM AG

## Beschreibung

Die Erfindung betrifft ein Netzleitungsfilter für 3-Phasen-Systeme, mit einem metallischen Filtergehäuse, das durch Trennwände in hochfrequenzdichte Kammern unterteilt ist, in denen in Reihe ein Netzanschlußteil, eine erste Kombination von Durchführungskondensatoren, Dämpfungsglieder, eine zweite Kombination von Durchführungskondensatoren und ein Lastanschlußteil untergebracht sind, wobei die Phasen- und der Mittelpunktsleiter (MP-Leiter) je durch einen, jeweils im Trennwandbereich vom Netzanschlußteil zur ersten bzw. von der zweiten Kombination von Durchführungskondensatoren zum Lastanschlußteil angeordneten, ringförmigen Durchführungskondensator geführt sind.

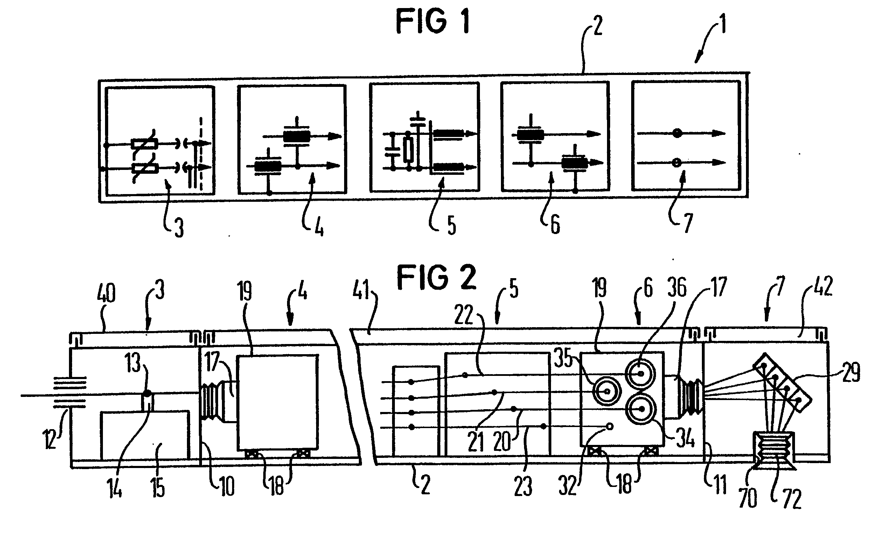

Ein Filtergehäuse 2 samt Netzleitungsfilter 1 dieser Art ist in Fig. 1 dargestellt. Mit 3, 4, 5, 6 bzw. 7 sind dabei das Netzanschlußteil, eine erste Kombination von Durchführungskondensatoren, ein Dämpfungsglied, das die für hohe Dämpfungen notwendigen π/2-Glieder enthält, eine zweite Kombination von Durchführungskondensatoren und das Lastanschlußteil bezeichnet.

Durch dieses Filter sind fünf Leiter, nämlich drei Phasenleiter, ein Mittelpunktsleiter und ein Masseleiter geschleift, der unmittelbar mit dem Filtergehäuse verbunden ist.

Das Filtergehäuse dieses Netzleitungsfilters ist mittels Trennwänden in z.B. drei hochfrequenzdicht gegeneinander geschirmte Kammern unterteilt, wobei in der ersten und letzten Kammer das Netzanschluß- bzw. Lastanschlußteil und in der mittleren die erste und zweite Kombination von Durchführungskondensatoren und das zwischen diese geschaltete Dämpfungsglied untergebracht sind.

Die US-A 3 909 623 beschreibt ein Netzleitungsfilter, mit einem metallischen Filtergehäuse, das durch Trennwände in hochfrequenzdichte Kammern unterteilt ist, in denen in Reihe ein Netzanschlußteil, eine erste Kombination von Durchführungskondensatoren, Dämpfungsglieder, eine zweite Kombination von Durchführungskondensatoren und ein Lastanschlußteil untergebracht sind, wobei die Leiter durch einen Durchführungskondensator geführt sind, und wobei die Kombination von Durchführungskondensatoren in einem zusätzlichen im Filtergehäuse stoßfest gelagerten, zur Aufnahme dieser Kondensatoren bestimmten Durchführungskondensatorgehäuse (19) untergebracht sind.

Der vorliegenden Erfindung liegt die Aufgabe zugrunde, ein Netzleitungsfilter im Baukastenprinzip und mit geringem Ableitstrom zu schaffen, das sich durch einen weiten Entstörfrequenzbereich, einfache Zusammenbaumöglichkeit, kostengünstige Fertigung, einfache elektrische Anschlußmöglichkeit, hohe Schüttelfestigkeit ( > 5g bei 55 Hz) und Stoßfestigkeit (>25 g) auszeichnet.

Zur Lösung dieser Aufgabe schlägt die Erfindung bei einem Netzleitungsfilter der eingangs genannten Art je Kombination von Durchführungskondensatoren Phasen-Durchführungskondensatoren vor, die in einem zusätzlichen im Filtergehäuse stoßfest gelagerten und im folgenden Durchführungskondensatorgehäuse bezeichneten Gehäuse untergebracht sind, daß der jeweils zwischen der Trennwand und dem Durchführungskondensatorgehäuse im Trennwandbereich angeordneten ringförmigen Durchführungskondensatoren mit seinem einen Belag, fest mit dem jeweiligen Durchführungskondensatorgehäuse und mit seinem anderen Belag mit einem durch den Durchführungskondensator geführten metallischen Wellschlauch verbunden ist, der am zur Trennwand gekehrten Ende einen Ring trägt, der mit einem in die Trennwand eingesetzten Dichtring hochfrequenzdicht verbunden, insbesondere verschraubt ist.

Bevorzugte Weiterbildungen dieses Netzleitungsfilters sind den Unteransprüchen entnehmbar.

Die Erfindung wird nachstehend anhand eines Ausführungsbeispieles näher erläutert.

Es zeigt:

Fig. 2 ein Netzleitungsfilter nach der Erfindung, dessen Prinzipschaltung Fig. 1 wiedergibt, in schematischer Darstellung,

Fig. 3 den für beide Kombinationen von Durchführungskondensatoren gleichen Aufbau und ihre Schaltung,

Fig. 4 in teils gebrochener und geschnittener Ansicht, sowie in vergrößertem Maßstab die ringförmigen Durchführungskondensatoren in den Trennwandbereichen,

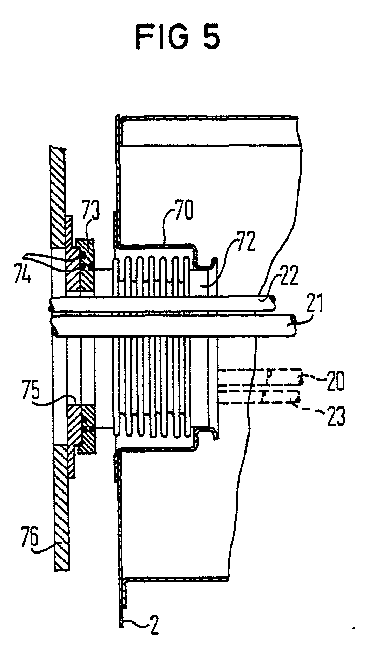

Fig. 5 in der Darstellung nach Fig. 4 ein als Anschluß z.B. für einen geschirmten Raum gestaltetes Teil eines Lastanschlusses.

Das Filtergehäuse 2 ist durch Trennwände 10, 11 in drei zueinander hochfrequenzdichte Kammern unterteilt, die jeweils durch Deckel 40, 41, 42 mit eingelegten Dichtschnüren Hf-dicht verschließbar sind.

Die in Fig. 2 linksseitig dargestellte erste Kammer besitzt eine Anschlußöffnung 12 mit Biegeverschraubung, durch welche die Phasenleiter 20, 21, 22 und der Mittelpunktsleiter 23 zum Filteranschluß 13 geführt sind. Dieser Anschluß liegt über einen Spannungsableiter 14 und Varistor 15 in kürzest möglicher Verbindung an der Masse des Filtergehäuses 2.

Vom Filteranschluß 13 gelangen die Phasen - und der MP-Leiter durch eine Bohrung in der metallischen Trennwand 10 und durch einen an diese Bohrung herangeführten Durchführungskondensator 17 zu einer Kombination von PhasenDurchführungskondensatorn 34, 35, 36, durch welche jeweils einer der Phasenleiter 20, 21, 22 läuft. Die genannte Kombination ist in einem Hf-dicht verschlossenen metallischen Durchführungskondensatorgehäuse 19 untergebracht, das mittels vier Puffern 18 stoß- und schüttelsicher im Filtergehäuse 2 gelagert ist.

Die Phasen-Durchführungskondensatoren 34, 35 und 36 sind parallel zur Filtergehäuselängsachse ausgerichtet, wodurch eine wesentlich vereinfachte Verbindung zwischen diesen Kondensatoren und dem Filteranschluß 13 geschaffen wird. Ferner erhält man so eine nur geringen Aufwand mögliche Verschaltung zwischen den Phasen-Durchführungskondensatoren 34, 35, 36, einer am Filtergehäuse 2 angeordneten Verbindungsschraube 32 für den MP-Leiter 23 und den Dämpfungsgliedern 5, nämlich π/2-Gliedern, die der ersten Kombination 4 von Durchführungskondensatoren nachgeschaltet sind. Insbesondere für Netzleitungsfilter mit hohen Stromstärken und mit wenig elastischen Vorschaltleitungen ist diese einfache Verschaltung wichtig.

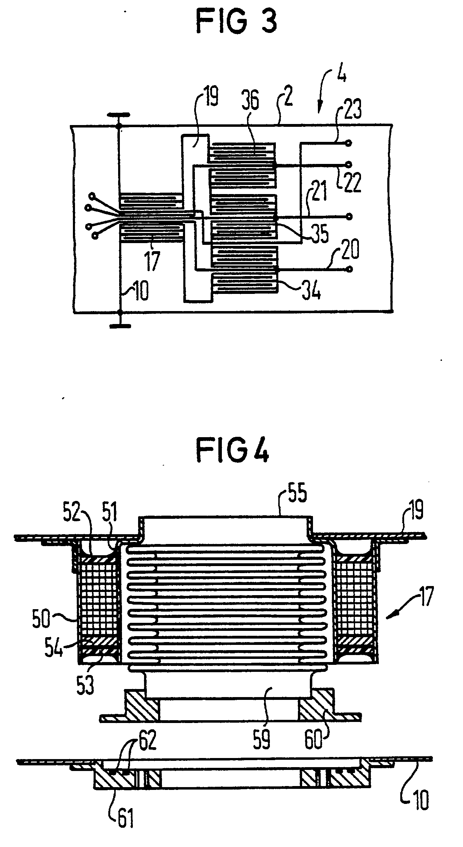

Der zwischen der Trennwand 10 und dem Durchführungskondensatorgehäuse 19 angeordnete Durchführungskondensator 17 ist gemäß Fig. 3, 4 ringförmig gestaltet und umschließt konzentrisch einen metallischen Wellschlauch 55. Der innere Belag 51 des Durchführungskondensators 17 ist an seinem zum Durchführungskondensator 19 gekehrten Ende mit dem entsprechenden Ende des Wellschlauchs 55 verbunden, z.B. hartverlötet und taucht mit diesem Ende durch eine Durchbrechung im Durchführungskondensatorgehäuse (19) in dieses ein. Der äußere Belag 50 dieses Kondensators ist mit seinem zum Durchführungskondensatorgehäuse 19 gekehrten, rechtwinklig zum Kondensator ausgerichteten Flanschteil mit dem Durchführungskondensatorgehäuse 19 Hf-dicht verschweißt. Die Stirnenden des Kondensators 17 sind mittels Gießharzscheiben 52, 53 isoliert, wobei die Gießharzscheibe 53 auf der ringscheibenförmigen, metallischen Stirnkontaktierung 54 aufliegt.

Das zur Trennwand 10 gekehrte Wellschlauchende 59 trägt einen mit einem Flansch und mit Bohrungen für Schraubverbindungen ausgerüsteten Ring 60, der mit einem entsprechenden, mit Gewindebohrungen 66 versehenen Dichtring 61 Hf-dicht verschraubbar ist.

Der Dichtring 61 besitzt zur Gewährleistung der Hf-dichten Verbindung Ringnuten 62, in denen in der Zeichnung nicht dargestellte Dichtschnüre angeordnet sind und ist mit der Trennwand 10 verschweißt.

Gemäß dem Schaltbild nach Fig. 3 sind die einen Beläge der Phasen-Durchführungskondensatoren 34, 35, 36 mit den Phasenleitern 20, 21 bzw 22 verbunden, so daß diese Kondensatoren zwischen den Phasenleitern 20, 21 bzw. 22 und dem MP-Leiter 23 und dieser mit dem Durchführungskondensator 17 gegen Masse geschaltet sind. Damit wird eine Dämpfung des Filters für Frequenzen bis über 35 GHz (Meßgrenze) bei > 100 dB gewährleistet.

Der ersten Kombination 4 von Durchführungskondensatoren sind - wie bereits erwähnt - in an sich bekannter Weise verschaltete Dämpfungsglieder 5, nämlich π/2-Glieder nachgeschaltet. Die Höhe ihrer Induktivitäten, Kapazitäten und Widerstände richtet sich dabei nach dem gewünschten Frequenzbereich, und zwar nach niedrigen Frequenzen hin.

Den Dämpfungsgliedern 5 ist wiederum eine zweite Kombination 6 von Durchführungskondensatoren 34, 35, 36 nachgeschaltet, die mit der bereits ausführlich erläuterten ersten Kombination gleich ist, weshalb sich ihre nochmalige detaillierte Beschreibung erübrigt. Aufgrund des selben Aufbaus sind diese Kombinationen und ihre Gehäuse vertauschbar.

Die Phasenleiter 20 bis 22 und der MP-Leiter 23 sind - wie beschrieben - durch den Durchführungskondensator 17 dieser zweiten Kombination und durch eine entsprechende Durchbrechung in der Trennwand 11 zu einer Klemmleiste 29 im Lastanschlußteil 7 und von dieser durch einen Hf-dicht in das Filtergehäuse 2 eingelassenen Wellschlauch 72 nach außen geführt.

Das Filtergehäuse 2 weist zu diesem Zweck im Bereich des Lastanschlußteils 7 eine Durchbrechung auf, durch die ein metallisches Rohr in das Filtergehäuseinnere eintaucht. Im Rohr 70, das mit seinem äußeren Ende mit dem Filtergehäuse 2 hochfrequenzdicht verschweißt ist, ist der erwähnte metallische Wellschlauch 72 geführt, der wiederum mit seinem Ende im Filtergehäuseinneren mit dem entsprechenden inneren Rohrende verschweißt ist. Das äußere Ende des Wellschlauchs 72 trägt einen Ring 73, mittels dem der Wellschlauch 72 mit einem z.B. in einen durchbrochenen Teil einer Wandung 76 eines geschirmten Raumes hochfrequenzdicht eingelassenen Dichtring 75 verschraubbar ist. Der Ring 73 besitzt ringförmige Nuten 74, in welche Dichtschnüre eingelegt sind.

Durch einen derart gestalteten Ausgangskamin sind das Netzleitungsfilter und damit die Leiter stoß- und erschütterungsfrei an den zu schirmenden Raum anschließbar, so daß die geforderte hochfrequenzmäßige Schirmung stets gegeben ist.

Dieses Netzleitungsfilter ist im Baukastenprinzip aufgebaut, weshalb die einzelnen Einheiten, d.h. z. B. die Kombinationen von Durchführungskondensatoren samt Gehäusen, die Dämpfungsglieder und dergleichen, außerhalb des Filtergehäuses montiert und Hf-dicht in das Filtergehäuse eingesetzt bzw. mit diesem verschraubt werden können. Die Fertigung und Montage läßt sich so erheblich vereinfachen.

**Patentansprüche**

1. Netzleitungsfilter für 3-Phasen-Systeme, mit einem metallischen Filtergehäuse, das durch Trennwände in hochfrequenzdichte Kammern unterteilt ist, in denen in Reihe ein Netzanschlußteil, eine erste Kombination von Durchführungskondensatoren, Dämpfungsglieder, eine zweite Kombination von Durchführungskondensatoren und ein Lastanschlußteil untergebracht sind, wobei die Phasen- und ein Mittelpunktsleiter durch je einen jeweils im Trennwandbereich vom Netzanschlußteil zur ersten bzw. von der zweiten Kombination von Durchführungskondensatoren zum Lastanschlußteil angeordneten Durchführungskondensator geführt sind, und wobei die Kombination von Durchführungskondensatoren und Phasen-Durchführungskondensatoren (34, 35, 36) in einem zusätzlichen im Filtergehäuse (2) stoßfest gelagerten, zur Aufnahme dieser Phasen-Durchführungskondensatoren bestimmten Durchführungskondensatorgehäuse (19) untergebracht sind und, der jeweils zwischen der Trennwand und dem Durchführungskondensatorgehäuse (19) angeordnete ringförmige Durchführungskondensator (17) mit seinem einen Belag (50) fest mit dem Durchführungskondensatorgehäuse (19) und mit seinem anderen Belag (51) mit einem durch diesen Durchführungskondensator geführten metallischen Wellschlauch (55) verbunden ist, der am zur Trennwand (10 bzw. 11) gekehrten Ende (59) einen Ring (60) trägt, der mit einem in die Trennwand (10 bzw. 11) eingesetzten Dichtring (61) hochfrequenzdicht verbunden, insbesondere verschraubt ist.

2. Netzleitungsfilter nach Anspruch 1, dadurch gekennzeichnet, daß die Phasen-Durchführungs kondensatoren (34, 35, 36) in ihrem Durchführungskondensatorgehäuse (19) senkrecht zur Längsachse des Filtergehäuses (2) ausgerichtet sind.

3. Netzleitungsfilter nach Anspruch 1, dadurch gekennzeichnet, daß der Dichtring (61) ringförmige Nuten (62) zur Aufnahme von Dichtschnüren aufweist.

4. Netzleitungsfilter nach Anspruch 1, dadurch gekennzeichnet, daß das Durchführungskondensatorgehäuse (19) mittels Puffer (18) im Filtergehäuse (2) stoß- und schüttelfest gelagert ist.

5. Netzleitungsfilter nach Anspruch 1, dadurch gekennzeichnet, daß das Filtergehäuse (2) im Bereich des Lastanschlußteiles (7) durchbrochen ist, daß durch die Durchbrechung ein metallisches Rohr (70) in das Filtergehäuseinnere eintaucht, das mit seinem äußeren Ende mit dem Filtergehäuse (2) hochfreuenzdicht verschweißt ist, daß in das Rohr (70) ein metallischer Wellschlauch (72) eingeführt ist, der mit seinem im Filtergehäuseinneren angeordneten Ende mit dem inneren Ende des Rohres hochfrequenzdicht verbunden ist, und daß das äußere Ende des Wellschlauchs einen Ring (73) trägt, mittels dem der Wellschlauch mit einem in die Wandung (76) eines geschirmten Raumes hochfrequenzdicht eingelassenen Dichtring (75) verbindbar, insbesondere verschraubbar ist.

**Claims**

1. Power line filter for 3-phase systems having a metallic filter housing which is subdivided by partitions into RF shielded chambers in which, in succession, a power supply part, a first assembly of feed-through capacitors, attenuation elements, a second assembly of feed-through capacitors and a load connecting part are accommodated, the phase conductors and one neutral conductor each being conducted via one feed-through capacitor arranged in each case in the partition region from the power supply part to the first combination of feed-through capacitors or from the second combination of feed-through capacitors to the load connecting part, and the assembly of feed-through capacitors and phase feed-through capacitors (34, 35, 36) being accommodated in an additional feed-through capacitor housing (19) which is mounted in an impact-resistant manner in the filter housing (2) and intended for receiving these phase feed-through capacitors, and the annular feed-through capacitor (17) arranged in each case between the partition and the feed-through capacitor housing (19) being connected by its one coating (50) permanently to the feed-through capacitor housing (19) and by its other coating (51) to a metallic corrugated hose (55) guided through this feed-through capacitor, said metallic corrugated hose bearing a ring (60) on the end (59) turned towards the partition (10 or 11), said ring being connected in an RF shielded manner, preferably being screwed, to a sealing ring (61) inserted into the partition (10 or 11).

2. Power line filter according to Claim 1, characterized in that the phase feed-through capacitors (34, 35, 36) in their feed-through capacitor housing (19) are aligned perpendicular to the longitudinal axis of the filter housing (2).

3. Power line filter according to Claim 1, characterized in that the sealing ring (61) has annular grooves (62) for receiving packing cords.

4. Power line filter according to Claim 1, characterized in that the feed-through capacitor housing (19) is mounted in an impact-free and vibration-free manner in the filter housing (2) by means of buffers (18).

5. Power line filter according to Claim 1, characterized in that the filter housing (2) is broken through in the region of the load connecting part (7), in that a metallic tube (70) dips into the inside of the filter housing, said tube being welded by its outer end to the filter housing (2) in an RF shielded manner, in that a metallic corrugated hose (72) is inserted into the tube (70), said corrugated hose being connected in an RF shielded manner by its end arranged inside the filter housing to the inner end of the tube, and in that the outer end of the corrugated hose bears a ring (73), by means of which the corrugated hose can be connected, in particular screwed, to a sealing ring (75) set into the wall (76) of a shielded space in an RF shielded manner.

**Revendications**

1. Filtre de ligne de réseau pour des systèmes triphasés, avec un boîtier de filtre métallique qui est subdivisé par des parois de séparation en des chambres étanches aux hautes fréquences, dans lesquelles sont logés, en série, une unité de raccordement au réseau, une première combinaison de condensateurs de traversée, des atténuateurs, une seconde combinaison de condensateurs de traversée et une unité de branchement de la charge, du type dans lequel les conducteurs de phase et un conducteur ou fil neutre passent respectivement par un condensateur de traversée disposé dans la zone de la paroi de séparation entre l'unité de raccordement et la première combinaison ou entre la seconde combinaison de condensateurs de traversée et l'unité de branchement de la charge, et dans lequel la combinaison de condensateurs de traversée et de condensateurs de traversée des phases (34, 35, 36) est logé dans un boîtier de condensateurs de traversée supplémentaire (19) monté de manière à résister aux chocs, dans le boîtier du filtre (2), et destiné à recevoir lesdits condensateurs de traversée des phases, alors que le condensateur de traversée (17) de forme annulaire, disposé entre la paroi de séparation et le boîtier de condensateur de traversée (19) est relié par son armature (50) rigidement au boîtier de condensateur de traversée (19), et est relié par son autre armature (51) à un tube métallique ondulé (55) qui passe par ce condensateur de traversée, lequel tube métallique ondulé porte, à l'extrémité (59) qui est voisine de la paroi de séparation (10, 11) un anneau (60) qui est relié, en particulier vissé de manière étanche aux hautes fréquences, avec une bague d'étanchéité (61) insérée dans la paroi de séparation (10, 11).

2. Filtre de ligne de réseau selon la revendication 1, caractérisé par le fait que des condensateurs de traversée des phases (34, 35, 36) sont dressés dans leur boîtier de condensateur de traversée (19), perpendiculairement à l'axe longitudinal du boîtier de filtre (2).

3. Filtre de ligne de réseau selon la revendication 1, caractérisé par le fait que la bague d'étanchéité (61) comporte des gorges (62) de forme annulaire pour recevoir des cordons d'étanchéité.

4. Filtre de ligne de réseau selon la revendication 1, caractérisé par le fait que le boîtier de condensateurs de traversée (19) est monté dans le boîtier de filtre (2) à l'aide de tampons (18) de manière à résister aux chocs et aux secousses.

5. Filtre de ligne de réseau selon la revendication 1, caractérisé par le fait que le boîtier de filtre (2) présente une ouverture dans la zone de l'unité de branchement de la charge (7), qu'à travers l'ouverture un tube métallique (70) plonge dans le boîtier de filtre, ledit tube étant soudé au boîtier de filtre (2) de manière étanche aux hautes fréquences, que dans le tube (70) est introduit un tuyau métallique ondulé (72) qui est relié, avec étanchéité aux hautes fréquences, par son extrémité disposée à l'intérieur du boîtier de filtre, à l'extrémité intérieure du tube, et que l'extrémité extérieure du tuyau ondulé porte une bague (73) à l'aide de laquelle le tuyau ondulé est susceptible d'être relié, en particulier d'être vissé à une bague d'étanchéité (75) sertie, de manière étanche aux hautes fréquences, dans la paroi (76) d'une chambre blindée.

# FIG 1

# FIG 2

EP 0 250 919 B1

# FIG 3

# FIG 4

# FIG 5